# EUROPEAN PATENT APPLICATION

(11) **EP 3 171 111 A1**
(43) Date of publication of application: **24.05.2017**
(21) Application number: 16181784.6
(22) Date of filing: 28.07.2016
(51) Int. Cl.: F28D 15/04, F28F 13/00, F28F 13/18, H01L 23/34, H05K 7/20, F28D 15/02, H01L 23/473

(54) **EVAPORATOR ASSEMBLY**

(30) Priority: 23.11.2015 US 201514949010
(71) Applicant: L-3 Communications Corporation, New York, NY 10016 (US)
(72) Inventor: Weber, Richard M., Prosper, TX Texas 75078 (US); Rodgers, John Michael, Farmers Branch, TX Texas 75234 (US); Spitzner, Matthew J., Lowry Crossing, TX Texas 75407 (US)
(74) Representative: Hanratty, Catherine

(57) **Abstract**

An evaporator apparatus comprising a liquid distribution chamber and a vapor production chamber. The vapor production chamber comprises a media wick that absorbs heat from a source external to the vapor production chamber. The vapor production chamber is configured to receive liquid coolant from the liquid distribution chamber and to direct the received liquid coolant onto a surface of the media wick. The media wick distributes the received liquid coolant from the surface of the media wick throughout a body of the media wick. The heat absorbed by the media wick vaporizes the liquid coolant distributed throughout the body of the media wick. The coolant vapor flows from the media wick into the vapor production chamber.

## Description

### TECHNICAL FIELD

The present application relates generally to cooling systems and, more specifically, to a two-phase evaporator assembly that transports away from a surface.

### BACKGROUND

Many industrial systems, mechanical apparatuses, electronic systems, and vehicles produce large amounts of waste heat. For example, high performance computers and servers with a large number of similar electronic devices produce a large amount of waste heat. It is necessary to remove this waste heat from the system in order to prevent damage to the electronic components due to overheating and to ensure performance.

One conventional system for removing heat is a two-phase evaporator. Ideally, a two-phase evaporator provides a near uniform flow of coolant over the surface of the evaporator so that similar devices see very similar thermal impedances. Otherwise, there could be excessive temperature differences between similar devices. Also, the evaporator should be able to supply the coolant to the evaporating surface regardless of the orientation of the evaporator. The evaporator should also ensure proper coolant distribution without "flashing" ofthe coolant within the evaporator distribution system

Therefore, there is a need in the art for an improved cooling apparatus for removing waste heat from a heat-producing system.

### SUMMARY

To address the above-discussed deficiencies of the prior art, it is a primary object to provide a two-phase evaporator to provide cooling to a heat-producing system. The disclosed two-phase evaporator comprises heat load of near uniform heat flux over the surface of the evaporator. At the same time, the disclosed two-phase evaporator has all portions of the surface ofthe evaporator at essentially the same operating temperature. The evaporator may use coolants such as water, methanol, or a fluorocarbon-based fluid (e.g., Fluorinert®), wherein heat is absorbed as these coolants go through a phase change from a liquid phase to a gas or vapor phase.

It is a primary object to provide an evaporator apparatus comprising: 1) a liquid distribution chamber; and 2) a vapor production chamber comprising a media wick that absorbs heat from a source external to the vapor production chamber. The vapor production chamber is configured to receive liquid coolant from the liquid distribution chamber and to direct the received liquid coolant onto a surface of the media wick.

In one embodiment of the disclosure, the media wick distributes the received liquid coolant from the surface of the media wick throughout a body of the media wick.

In another embodiment, the heat absorbed by the media wick vaporizes the liquid coolant distributed throughout the body of the media wick and wherein the coolant vapor flows from the media wick into the vapor production chamber.

In still another embodiment, the media wick is fused to an exterior wall of the vapor production chamber.

In yet another embodiment, the media wick comprises sintered copper microballs.

In a further embodiment of the disclosure, the media wick comprises a porous material that uses capillary action to distribute the received liquid coolant from the surface ofthe media wick throughout a body of the media wick.

In a still further embodiment, the evaporator apparatus further comprises a plurality of nozzles disposed in a common wall separating the liquid distribution chamber and the vapor production chamber. The plurality of nozzles are configured to transport the liquid coolant from the liquid distribution chamber into the vapor production chamber and to direct the liquid coolant onto the surface of the media wick.

In a yet further embodiment, the liquid distribution chamber receives the liquid coolant from an external supply and is configured to maintain a pressure of the liquid coolant above the saturation pressure of the liquid coolant at the highest temperature at which the evaporator apparatus is expected to operate.

Before undertaking the DETAILED DESCRIPTION below, it may be advantageous to set forth definitions of certain words and phrases used throughout this patent document: the terms "include" and "comprise," as well as derivatives thereof, mean inclusion without limitation; the term "or," is inclusive, meaning and/or; the phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like. Definitions for certain words and phrases are provided throughout this patent document, those of ordinary skill in the art should understand that in many, if not most instances, such definitions apply to prior, as well as future uses of such defined words and phrases.

### BRIEF DESCRIPTION OF THE DRAWINGS

For a more complete understanding of the present disclosure and its advantages, reference is now made to the following description taken in conjunction with the accompanying drawings, in which like reference numerals represent like parts:
FIGURE 1 illustrates a two-phase evaporator according to one embodiment of the disclosure.
FIGURE 2 illustrates a two-phase evaporator in greater detail according to one embodiment of the disclosure.

### DETAILED DESCRIPTION

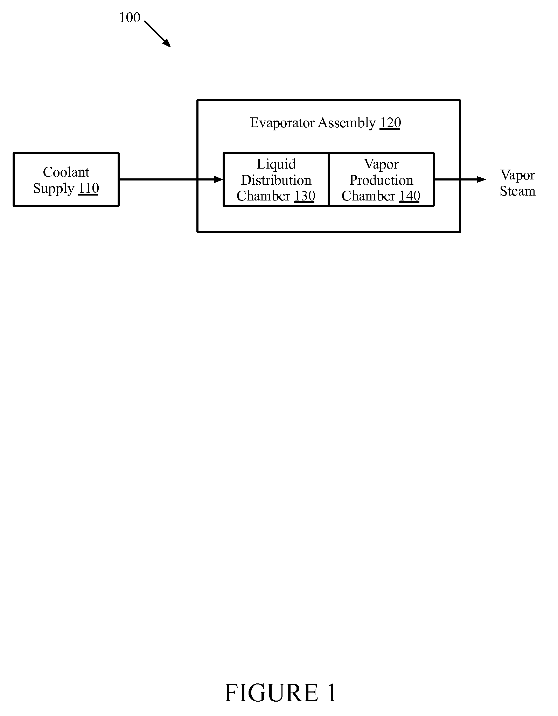

FIGURES 1 through 2, discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged evaporator assembly.

FIGURE 1 illustrates two-phase evaporator 100 according to one embodiment of the disclosure. Evaporator 100 comprises coolant supply 110, and evaporator assembly 120. Evaporator assembly 120 comprises a liquid distribution chamber 130 and a vapor production chamber 140. Coolant is injected under pressure from the coolant supply 110 into liquid distribution chamber 130. During operation, the coolant pressure into and within liquid distribution chamber 130 is greater that than the highest anticipated saturation pressure of the coolant. Exemplary coolants may be water, methanol, or a fluorocarbon-based fluid (e.g., Fluorinert®). At the exit of vapor production chamber 140, the vapor stream may be condensed using a heat exchanger and recirculated as part of a closed-loop system or may be vented as part of an open-loop system.

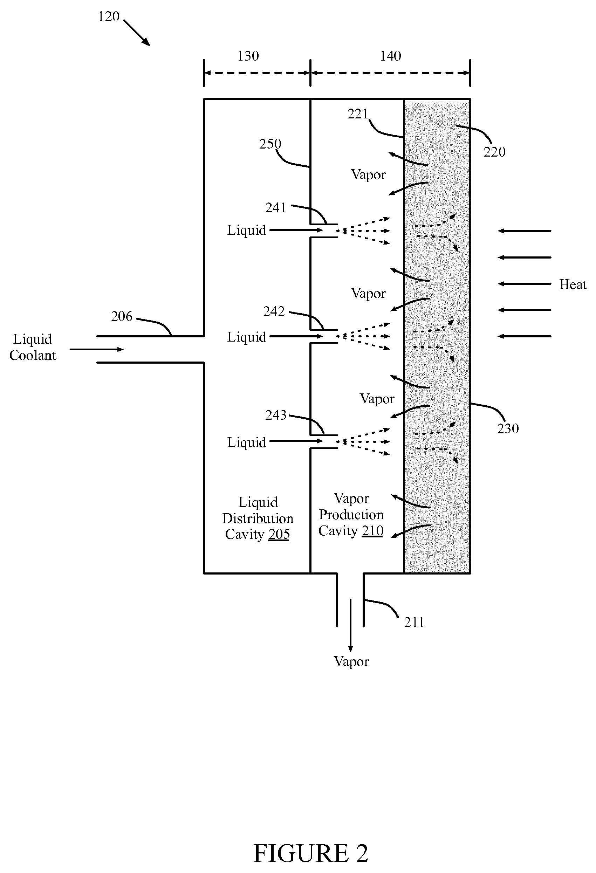

FIGURE 2 illustrates two-phase evaporator assembly 120 in greater detail according to one embodiment of the disclosure. Evaporator assembly 120 comprises liquid distribution chamber 130 and vapor production chamber 140, as noted in FIGURE 1. The walls of liquid distribution chamber 130 form liquid distribution cavity 205. Coolant inlet 206 brings liquid coolant from coolant supply 110 into liquid distribution cavity 205. The walls of vapor production chamber 140 form vapor production cavity 210. Vapor outlet 211 removes vapor from vapor production cavity 210 to an external vent (open loop system) or a condenser (closed loop system).

Wall 250 separates the cavities of liquid distribution chamber 130 and vapor production chamber 140. Vapor production chamber140 contains porous media wick 220, which is formed (e.g., fused) against the inner surface of exterior wall 230 of vapor production chamber 140. The outer surface of exterior wall 230 receives the waste heat (thermal energy) that must be eliminated.

A plurality of jetting nozzles, including exemplary nozzles 241, 242 and 243, among others, inject liquid coolant under pressure into vapor production cavity 210 and onto inner surface 221 of media wick 220. The coolant that impinges on surface 221 is absorbed into media wick 220 (shaded area). According to the principals of the present disclosure, media wick 220 is a porous and dense material that exhibits high capillary action pressure (local spreading) that absorbs the impinged liquid coolant and distributes the absorbed liquid coolant uniformly throughout the body (shaded area) of media wick 220. By way of example, media wick 220 may comprise sintered copper micro-balls (or a similar device), similar to the wick inside of a heat pipe.

In FIGURE 2, the pressure ofthe liquid coolant that fills liquid distribution cavity 205 is kept high to increase the boiling point of the liquid coolant. Thus, the fluid manifold pressure is maintained greater than the highest anticipated saturation pressure (Pₛₐₜᵤᵣₐₜᵢₒₙ) of the liquid coolant so that the coolant remains in a fluid state in liquid distribution chamber 205 and as it is injected through exemplary nozzles 241, 242, and 243.

Jet nozzles 241, 242, and 243 are evenly distributed and closely spaced (e.g., 1/8 inch to 3/8 inch) to ensure a uniform distribution of liquid coolant onto surface 221 of media wick 220. In FIGURE 2, the dotted line arrows pointing from left to right indicate sprays ofliquid coolant leaving nozzles 241, nozzle 242, and nozzle 243 and impinging on surface 221 of media wick. The array of jet nozzles sprays coolant onto the porous media wick 220, which captures the liquid coolant and transports it small distances using capillary action. The dotted line curved arrows within the body of media wick 220 indicate the internal distribution of the liquid coolant via capillary action. Jetting streams of liquid coolant flow through the orifices of nozzles 241, 242, 243, with sufficient pressure drop at required flow rates to ensure an upstream pressure that is above the worst-case saturation pressure of the coolant.

Media wick 220 has sufficient thickness and capillary pressure to transport the coolant with sufficient flow rate from the jetting impact sites to all portions of the internal, porous structure of media wick 220. The jetting spay provides wide area, near uniform coolant distribution of liquid coolant into the lower pressure vapor production cavity 210.

The waste heat that impinges on wall 230 enters media wick 220 and heats and vaporizes the liquid coolant as the liquid coolant is distributed closer to outer wall 230. The vaporized coolant is forced from media wick 220 into vapor production cavity 210. The solid line curved arrows pointing from right to left indicate vaporized coolant leaving the body of media wick 220 and entering vapor production cavity 210. The vaporized coolant then exits vaporproduction cavity 210 via outlet 211.

The present disclosure describes an evaporator that uses an array of multiple, jetting streams of a coolant to ensure even distribution onto a porous, wicking media, which is fused to the inner surface of a wall of the evaporator assembly. The wicking media transports the coolant from liquid jet impact sites into areas in the body of the wicking media, where waste heat from components mounted on the opposing outer surface of the wall is absorbed as the coolant changes from a liquid to a vapor. The jetting streams flow through restricting orifices to ensure the pressure of the coolant in its supply manifold is above the saturation pressure of the coolant at the highest temperature of the supplied coolant that will be seen in operation. This ensures that only liquid is distributed by the array of jetting streams.

The disclosed two-phase evaporator provides a near uniform flow of coolant over the surface of the evaporator to minimize excessive temperature differences between similar devices, such as electronic processors or amplifiers. The disclosed two-phase evaporator supplies the coolant to the evaporating surface regardless ofthe orientation ofthe evaporator and ensures proper coolant distribution without "flashing" of the coolant within the distribution system of the evaporator.

Although the present disclosure has been described with an exemplary embodiment, various changes and modifications may be suggested to one skilled in the art. It is intended that the present disclosure encompass such changes and modifications as fall within the scope of the appended claims.

## Claims

1. An evaporator apparatus comprising:
a liquid distribution chamber; and
a vapor production chamber comprising a media wick that absorbs heat from a source external to the vapor production chamber, wherein the vapor production chamber is configured to receive liquid coolant from the liquid distribution chamber and to direct the received liquid coolant onto a surface of the media wick.

2. The evaporator apparatus as set forth in Claim 1, wherein the media wick distributes the received liquid coolant from the surface of the media wick throughout a body ofthe media wick.

3. The evaporator apparatus as set forth in Claim 2, wherein the heat absorbed by the media wick vaporizes the liquid coolant distributed throughout the body of the media wick and wherein the coolant vapor flows from the media wick back into the vapor production chamber.

4. The evaporator apparatus as set forth in Claim 1, wherein the media wick is fused to an exterior wall of the vapor production chamber.

5. The evaporator apparatus as set forth in Claim 1, wherein the media wick comprises sintered copper microballs.

6. The evaporator apparatus as set forth in Claim 1, wherein the media wick comprises a porous material that uses capillary action to distribute the received liquid coolant from the surface of the media wick throughout a body of the media wick.

7. The evaporator apparatus as set forth in Claim 6, wherein the heat absorbed by the media wick vaporizes the liquid coolant distributed throughout the body of the media wick and wherein the coolant vapor flows from the media wick into the vapor production chamber.

8. The evaporator apparatus as set forth in Claim 6, wherein the media wick is fused to an exterior wall of the vapor production chamber.

9. The evaporator apparatus as set forth in Claim 6, wherein the media wick comprises sintered copper microballs.

10. The evaporator apparatus as set forth in Claim 1, further comprising a plurality of nozzles disposed in a common wall separating the liquid distribution chamber and the vapor production chamber, wherein the plurality of nozzles are configured to transport the liquid coolant from the liquid distribution chamber into the vapor production chamber and to direct the liquid coolant onto the surface of the media wick.

11. The evaporator apparatus as set forth in Claim 1, wherein the liquid distribution chamber receives the liquid coolant from an external supply and is configured to maintain a pressure of the liquid coolant above the saturation pressure of the liquid coolant at the highest temperature at which the evaporator apparatus is expected to operate.
